# EUROPÄISCHE PATENTSCHRIFT

(11) **EP 1 305 214 B1**
(45) Veröffentlichungstag und Bekanntmachung des Hinweises auf die Patenterteilung: **29.12.2004**
(21) Anmeldenummer: 01962583.9
(22) Anmeldetag: 01.08.2001
(51) Int. Cl.: B65B 15/04, H01L 21/00

(54) **VORRICHTUNG UND VERFAHREN ZUR BESTÜCKUNG VON TRANSPORTGURTEN**
DEVICE AND METHOD FOR THE PLACEMENT OF COMPONENTS ON TRANSPORT BELTS
DISPOSITIF ET PROCEDE D'IMPLANTATION DE COMPOSANTS DANS DES COURROIES DE TRANSPORT

(30) Priorität: 04.08.2000 DE 10038163
(43) Veröffentlichungstag der Anmeldung: 02.05.2003
(73) Patentinhaber: Infineon Technologies AG, 81669 München (DE)
(72) Erfinder: LEHNER, Rudolf, 93164 Laaber (DE); PAULUS, Stefan, 93197 Zeitlarn (DE)
(74) Vertreter: Schweiger, Martin
(86) Internationale Anmeldenummer: PCT/DE2001/002889
(87) Internationale Veröffentlichungsnummer: WO 2002/012066

(56) Entgegenhaltungen:
- GB-A- 850 090
- US-A- 3 465 874
- PATENT ABSTRACTS OF JAPAN vol. 1999, no. 09, 30. Juli 1999 (1999-07-30) & JP 11 091711 A (MATSUSHITA ELECTRIC IND CO LTD;NISSHO KK), 6. April 1999 (1999-04-06)
- PATENT ABSTRACTS OF JAPAN vol. 010, no. 270 (M-517), 13. September 1986 (1986-09-13) & JP 61 094737 A (MATSUSHITA ELECTRIC IND CO LTD), 13. Mai 1986 (1986-05-13)

## Beschreibung

Die Erfindung betrifft eine Vorrichtung und ein Verfahren zur Bestückung von Transportgurten mit elektronischen Bauteilen.

Derartige Transportgurte weisen vorgeformte Gurttaschen auf, in denen elektronische Bauteile lagegetreu angeordnet und transportiert werden können, sowie lagegetreu den Transportgurten entnommen werden können. Zum Transport werden die Gurttaschen eines Transportgurtes mit Hilfe eines Abdeckgurtbandes abgedeckt, so daß die elektronische Bauteile nicht aus den Gurttaschen herausfallen können und ihre Lage in Bezug auf die drei Raumachsen bis zur Entnahme aus den Transportgurten nicht ändern. Solche Transportgurte sind allgemein bekannt, siehe z.B. JP 11091711 oder GB 850 090 A. Beim Einbringen und Positionieren insbesondere von kleinen und/oder leichten elektronischen Bauteilen, wie sie in großer Stückzahl für die Hochfrequenztechnik, die Leucht- und Lasertechnik und dergleichen benötigt werden, ist ein schnelles Bestücken bei hoher Durchsatzrate mit der Gefahr verbunden, daß die Bauteile aus den Gurttaschen herausspringen und damit den Bestückungsvorgang eines Bestükkungsautomaten für Transportgurte erheblich behindern, zumal nicht nur die Bestückung zu unterbrechen ist, sondern der Automat gründlich nach den herausgesprungenen elektronischen Bauteilen abzusuchen und die Bestückungsposition des Automaten neu zu definieren und einzujustieren ist.

Ein weiteres Problem bei der Bestückung von Transportgurten mit kleinen und/oder leichten elektronischen Bauteilen im Milimeterbereich ist darin zu sehen, daß die Präzisionsanforderungen sowohl an die Formgebung der Gurttaschen als auch an den Bestückungsautomaten ständig steigende Investitions und Entwicklungskosten erfordern, um die elektronischen Bauteile präzise und lagegetreu in den Gurttaschen zu positionieren und um diesen Präzisionsanforderungen zu genügen.

Aufgabe der Erfindung ist es, eine Vorrichtung und ein Verfahren zur Bestückung von Transportgurten mit elektronischen Bauteilen anzugeben, mit denen eine zuverlässige und präzise Bestückung von Transportgurten mit elektronischen Bauteilen möglich ist.

Diese Aufgabe wird mit dem Gegenstand der unabhängigen Ansprüche gelöst, weitere Merkmale von Ausführungsformen der Erfindung ergeben sich aus den Unteransprüchen.

Erfindungsgemäß weist die Vorrichtung zur Bestückung von Transportgurten mit elektronischen Bauteilen einen Formträger mit mindestens einer Aussparung zur Formgebung von Gurttaschen für die Aufnahme elektronischer Bauteile in den Gurttaschen auf. Ferner weist die Vorrichtung ein Kunststoffband auf, das als flacher Rohgurt auf dem Formträger die Aussparung abdeckend angeordnet ist. Eine Heizung zur Erwärmung des Formträgers und/oder des Kunststoffbandes sowie ein Prägewerkzeug sind vorgesehen, wobei das Prägewerkzeug in seinem Prägebereich das elektronische Bauteil aufweist und die Gurttasche mittels dem im Prägebereich positionierten elektronischen Bauteil unter Einpressen des Kunststoffbandes in die Aussparung des Formträgers durch das elektronische Bauteil formbar ist.

Mit einer derartigen Bestückungsvorrichtung werden die Präzisionsanforderungen an den Bestückungsautomaten erheblich vermindert, da das Prägewerkzeug zur Einbringung von Gurttaschen in einen flachen Rohgurt das zu verpackende elektronische Bauteil in seinem Prägebereich aufweist, womit das elektronische Bauteil selbst die eng tolerierten Dimensionen der Gurttasche bestimmt und die Gurttasche ausformt und gleichzeitig der Transportgurt mit dem elektronischen Bauteil in der Gurttasche bestückt wird. Dieses bedeutet zusätzlich, daß die Positionierung des Kunststoffbandes auf dem Formträger keine besonders hohen Präzisionsanforderungen stellt. Auch die Aussparungen in dem Formträger müssen nur grob den Abmessungen des elektronischen Bauteils entsprechen, wobei eine Aussparungsgröße für mehrere Toleranzklassen der elektronischen Bauteile und somit ein Formträger für mehrere Toleranzklassen elektronischer Bauteile einsetzbar wird.

In einer bevorzugten Ausführungsform der Erfindung ist das Prägewerkzeug ein Bestückungselement eines Bestückungsautomaten, so daß der Bestückungsautomat das Prägewerkzeug im Prägebereich ständig mit elektronischen Bauteilen versorgt und ähnlich einer automatischen Stempelmaschine das Prägewerkzeug mit Hilfe des elektronischen Bauteils in seinem Prägebereich die Gurttaschen formt und gleichzeitig mit dem elektronischen Bauteil bestückt.

In einer weiteren Ausführungsform der Erfindung ist das Prägewerkzeug ein Prägestempel, in dessen Prägebereich das elektronische Bauteil mittels Vakuum fixierbar ist. Dieses hat den Vorteil, daß die Aufnahme des elektronischen Bauteils aus einer lagebestimmenden Zufuhreinrichtung, die Fixierung des Bauteils im Prägebereich des Prägewerkzeugs und die Formgebung der Gurttasche für das elektronische Bauteil in der Aussparung des Formträgers unter Vakuum ausführbar werden. Zur gleichzeitigen Bestückung des Transportgurtes mit dem elektronischen Bauteil ist lediglich die Vakuumfixierung des Bauteils im Prägebereich des Prägestempels aufzuheben, um das elektronische Bauteil in der selbstgeformten Gurttasche zu positionieren. Dazu weist das Prägewerkzeug eine zentrale evakuierbare Bohrung auf, mittels der das Bauteil im Prägebereich fixierbar ist, wenn die zentrale Bohrung in dem Prägewerkzeug mit Vakuum beaufschlagt wird.

Eine weitere Ausführungsform der Erfindung sieht vor, daß das Prägewerkzeug mit einer Antriebsmechanik verbunden ist, wodurch einerseits das Prägewerkzeug in Z-Richtung auf die Aussparung in dem Formträger zu und in den Richtungen X und Y orthogonal dazu verschiebbar ist. Diese Ausführungsform der Vorrichtung hat den Vorteil, daß das Prägewerkzeug in den Richtungen X und Y orthogonal zur Z-Richtung verschiebbar ist, nachdem das Prägewerkzeug in Z-Richtung in die Aussparung abgesenkt wurde. Die Verschiebung in X- und Y-Richtung kann durch eine Ultraschallschwingungsanregung erfolgen, wobei die Ultraschallamplitude einstellbar ist und somit die benötigte sehr enge Toleranz zwischen der eingeformten Gurttasche und den Abmessungen des elektronischen Bauteils herstellbar wird. Durch die Schaffung der Toleranz wird erreicht, daß ein Zugriff durch einen Entnahmeautomaten auf das in der Gurttasche positionierte Bauteil erleichtert ist und andererseits das elektronische Bauteil lagegetreu nach Bestückung und Transport beim Abnehmer entnommen werden kann. Ferner sind keine Transportgurte mit vorgefertigten Gurttaschen und entsprechend engen Toleranzen vorzubereiten, da die enge Toleranz durch das elektronische Bauteil selbst mit Hilfe des Prägewerkzeugs und der Bewegung in X- und Y-Richtung hergestellt wird.

Eine weitere Ausführungsform der Erfindung sieht vor, daß die Aussparung in dem Formträger in ihrem Bodenbereich eine evakuierbare Bohrung zur Formgebung der Gurttasche im Bodenbereich der Aussparung aufweist. Mit Hilfe dieser evakuierbaren Bohrung kann erreicht werden, daß der Bodenbereich der Gurttasche eng auf dem Bodenbereich der Aussparung aufliegt, so daß die Tiefe der Gurttasche durch die Tiefe der Aussparung in dem Formträger bestimmt wird und gleichzeitig der Stempeldruck auf das Prägewerkzeug bzw. das Bauelement, das die Gurttasche beim Bestücken ausformt, vermindert werden kann. Darüber hinaus wird die Gefahr unterschiedlicher Gurttaschentiefen vermindert, die sich eventuell beim Einpressen des Stempelwerkzeugs in die Aussparung mit dem dazwischenliegenden Kunststoffband ergeben könnten.

In einer weiteren Ausführungsform der Erfindung weist die Vorrichtung eine Hubvorrichtung für den Formkörper auf, die dem Anheben des Formkörpers in Richtung auf das Prägewerkzeug und dem Absenken in entgegengesetzter Richtung dient. Der Vorteil dieser Ausführungsform ist, daß der Formkörper als einfacher Stempel mit einer formgebenden Matritze auf seiner Stirnseite ausgebildet sein kann, wobei der Formkörper taktweise in Z-Richtung synchron zu dem Stempelwerkzeug aufeinander zu oder voneinander weg bewegt wird, um in dem flachen Rohgurt bzw. flachen Kunststoffband eine Gurttasche unter gleichzeitiger Bestückung der Gurttasche mit einem elektronischen Bauteil auszuformen.

In einer weiteren Ausführungsform der Erfindung weist der Formträger eine zylindrische Form auf und hat auf seinem Zylindermantel mindestens eine Aussparung zur Formgebung von Gurttaschen angeordnet. Ein derartiger zylindrischer Formträger hat den Vorteil, daß er um seine Zylinderachse gedreht werden kann, so daß nach dem Einformen der Gurttasche in der mindestens einen Aussparung auf dem Zylindermantel und Bestücken des Transportgurtes sowie nach Abziehen des Stempelwerkzeugs von dem elektronischen Bauteil durch Drehen des zylinderförmigen Formträgers der bestückte Transportgurt von dem Formträger getrennt werden kann. Zusätzlich können im Randbereich des Zylindermantels Noppen vorgesehen sein, die in eine entsprechende Perforation des Kunststoffbandes eingreifen und somit eine genaue Zuordnung der Abstände zwischen den Bestückungspositionen auf dem Transportgurt gewährleisten. Ist lediglich eine formgebende Aussparung auf dem Zylindermantel vorgesehen, so ergibt sich die nächste Bestükkungsposition nach einer Umdrehung des Zylindermantels um die Zylinderachse. Um den Abstand zwischen Bestückungspositionen auf dem Transportgurt zu verringern, können mehrere Aussparungen auf dem Zylindermantel vorgesehen sein, so daß ein erhöhter Durchsatz mit gleichzeitig vermindertem Abstand zwischen den Bestückungspositionen möglich wird. Ferner können mehrere Positionen für Aussparungen nebeneinander auf einer Mantellinie des Zylinders vorgesehen sein, um die Aufnahmekapazität des Transportgurtes zu erhöhen.

Anstelle einer zylindrischen Form für den Formträger mit kreisförmigem Querschnitt des Formträgers kann auch ein polygonaler Querschnitt vorgesehen werden. Deshalb weist in einer weiteren Ausführungsform der Erfindung der Formträger eine polygonale Säulenform auf und hat auf seinen polygonalen Kantenflächen jeweils mindestens eine Aussparung zur Formgebung von Gurttaschen angeordnet. Diese polygonale Säulenform des Formträgers hat den Vorteil, daß nach der Formgebung der Gurttasche beim Drehen des Formträgers um seine Drehachse die Kanten auf der Mantelfläche der polygonalen Säulenform die entstandene und bestückte Gurttasche aus der Aussparung auf der polygonalen Kantenfläche herausheben und damit ein Trennen des Formträgers von dem bestückten Transportgurt erleichtern.

Mit Hilfe eines geeigneten Antriebs kann ein derartiger zylindrischer oder polygonale Formträger durch Drehung um seine Rotationsachse taktweise eine Bestückungsposition in den Prägebereich des Prägewerkzeugs und aus dem Prägebereich des Prägewerkzeugs heraus drehen, während gleichzeitig das Prägewerkzeug selbst eine Stempelbewegung in Z-Richtung bzw. in Richtung auf die Aussparung und aus der Aussparung heraus durchführen kann.

Auf einem zylindrischen oder polygonalen Formträger können auch Aussparungen unterschiedlicher Größe vorgesehen sein, die je nach Größenbedarf in eine Bestückungsposition gedreht werden, wobei eine Trennung eines derart ausgebildeten Formträgers von dem bestückten Transportgurt durch eine entsprechende Hubbewegung des Formkörpers bewirkt werden kann.

Das Kunststoffband ist in einer Ausführungsform der Erfindung eine Polystyrolfolie oder eine Polycarbonatfolie, die zum taktweisen Weitertransport in die Bestückungsposition und aus der Bestückungsposition heraus mit einer Perforation im Randbereich des Kunststoffbandes versehen sein können.

In einer weiteren Ausführungsform der Erfindung weist das Kunststoffband einen Graphit- oder Kohlenstofffüller auf. Dieser Graphit- oder Kohlenstofffüller verbessert die elektrische Oberflächenleitfähigkeit des Kunststoffbandes, so daß elektrostatische Aufladungen während des Ausformens der Gurttasche insbesondere bei der Bewegung des Prägebereichs des Prägewerkzeuges mit dem elektronischen Bauteil orthogonal zu der Prägerichtung das elektronische Bauteil trotz Relativbewegung zwischen Kunststoffband und Bodenbereich des elektronischen Bauteils vermieden werden.

In einer weiteren Ausführungsform der Vorrichtung weist diese eine Zufuhreinrichtung eines Abdeckgurtbandes zum Abdecken der Gurttaschen auf. Diese Zufuhreinrichtung besteht im wesentlichen aus einer Umlenkrolle, die das Abdeckgurtband von einer Abwickelrichtung in einer Abdeckrichtung umlenkt, um den bestückten Transportgurt insbesondere im Bereich seiner Gurttaschen abzudecken. Zur Verbindung des Abdeckgurtbandes mit dem bestückten Transportgurt kann die Vorrichtung eine Kunststoffschweißeinrichtung oder eine Klebevorrichtung aufweisen, um das Abdeckgurtband im Bereich der Gurttaschen auf dem Transportgurtband aufzuschweißen oder aufzukleben.

In einer weiteren bevorzugten Ausführungsform der Erfindung weist die Vorrichtung zusätzlich einen Rotationskörper auf, auf den der bestückte Transportgurt mit dem Abdeckgurtband aufwickelbar ist, so daß die elektronischen Bauteile sicher in den Gurttaschen nach der Bestückung, während des Transports und bei der lagegetreuen Entnahme durch beispielsweise einen Bestückungsautomaten für Leiterplatten beim Abnehmer angeordnet bleiben.

Ein Verfahren zum Bestücken von Transportgurten mit elektronischen Bauteilen weist folgende Verfahrensschritte auf:
- Bereitstellen eines Formträgers mit mindestens einer Aussparung für Gurttaschen zur Aufnahme elektronischer Bauteile,
- Positionieren eines verformbaren flachen Kunststoffbandes auf dem Formträger im Bereich der Aussparung,
- Erwärmen des Formträgers und/oder des Kunststoffbandes,
- Aufnehmen eines elektronischen Bauteils mittels eines Prägewerkzeuges und Anordnen des elektronischen Bauteils in dem Prägebereich des Prägewerkzeugs,
- Einpressen des Prägebereichs des Prägewerkzeugs in die Aussparung des Formträgers unter Ausformung einer Gurttasche in dem auf der Aussparung angeordneten Kunststoffband und
- Entfernen des Prägewerkzeugs aus der Gurttasche unter Zurücklassung des elektronischen Bauteils in der Gurttasche.

Ein derartiges Verfahren hat den Vorteil, daß mit der Formgebung der Gurttaschen in einem flachen Rohgurt gleichzeitig das elektronische Bauteil die Innenabmessungen der Gurttasche bestimmt, so daß eng tolerierbare Gurttaschen verwirklicht werden können ohne hohe Präzisionsanforderungen an den Formträger, das Stempelwerkzeug sowie die Führung des zu verformenden flachen Kunststoffbandes.

In einer bevorzugten Ausführungsform des Verfahrens wird das Prägewerkzeug beim Einpressen in die Aussparung in den Richtungen orthogonal zu der Einpressrichtung bewegt. Dabei bestimmt die Größe der Bewegung die lose Passung des elektronischen Bauteils in der Gurttasche, so daß eine problemlose Entnahme des Bauteils aus der Gurttasche nach einem lagegetreuen Transport möglich wird, ohne daß sich das elektronische Bauteil um eine der drei Raumachsen, nämlich der Hochachse, der Längsachse und der Querachse, in der Gurttasche verdrehen kann. Diese lose Passung läßt sich somit eng an die Abmessungen des elektronischen Bauteils anpassen, wozu beispielsweise das Prägewerkzeug in den orthogonalen Richtungen zur Prägerichtung mittels eines Ultraschallgenerators ausgelenkt werden kann, wobei die enge Toleranz zwischen den Innenabmessungen der Gurttaschen und den Aussenabmessungen des elektronischen Bauteils durch die Amplitude des Ultraschalls bestimmt wird.

Bei einer bevorzugten Durchführung des Verfahrens werden das Prägewerkzeug und der Formträger nach dem Ausformen der Gurttasche unter gleichzeitiger Bestückung derselben mit einem elektronischen Bauteil auseinandergefahren und der entstandene Transportgurt bestückt mit einem elektronischen Bauteil in der Gurttasche wird aus der Bestückungsposition herausgefahren, während das flache Kunststoffband die nächste Bestükkungsposition einnimmt.

Bei dieser Durchführung des Verfahrens werden zur Bestückung und zur Einnahme der nächsten Bestückungsposition lediglich Hubbewegungen des Formträgers und des Stempelwerkzeugs taktweise durchgeführt, was die Anforderung an die Präzision des Verfahrens äußerst vereinfacht, zumal die Aussparung in dem Formträger nicht präzise den Amessungen des Bauteils und der Gurttasche angepaßt sein müssen, da letztendlich das elektronische Bauteil selbst beim Zusammenfahren von Prägewerkzeug und Formträger mit Aussparungen die Innenmaße der Gurttasche bestimmt. In einer weiteren Durchführung des Verfahrens kann das Prägewerkzeug nach dem Ausformen und dem gleichzeitigen Bestücken einer Gurttasche mit einem elektronischen Bauteil das nächste elektronische Bauteil in seinen Prägebereich aufnehmen. Dazu kann eine Zufuhreinrichtung das nächste Bauteil im auseinandergefahrenen Zustand von Prägewerkzeug und Formträger in den Eingriffsbereich des Prägewerkzeugs zur Aufnahme eines elektronischen Bauteils in seinen Prägebereich verfahren, so daß eine lagegetreue Aufnahme des elektronischen Bauteils in dem Prägebereich des Prägewerkzeugs gewährleistet ist.

Zur Erleichterung der Einformung einer Gurttasche mit Hilfe eines elektronischen Bauteils wird entweder das Kunststoffband und/oder der Formträger im Bereich der zu bildenden Gurttasche erwärmt, so daß in einer weiteren Durchführung des Verfahrens nach dem Einformen unter gleichzeitigem Bestücken einer Gurttasche der erwärmte Transportgurt aktiv gekühlt wird. Eine derartige aktive Kühlung kann mit Hilfe eines Luftstromes nach dem Trennen von Formträger und Transportgurt erfolgen.

Bei einer weiteren Durchführung des Verfahrens kann die bestückte Gurttasche zum Kühlen über eine wassergekühlte Oberfläche geführt werden. Mit beiden Verfahren wird vorteilhaft erreicht, daß die eingeformte Gurttasche in ihrer Form derart stabilisiert wird, daß beispielsweise der bestückte Transportgurt auf einen Rotationskörper aufgewickelt werden kann ohne eine nachträgliche Verformung der Gurttaschen.

Die für das Einformen von Gurttaschen möglicherweise notwendige Erwärmung des Formträgers kann mittels Stromfluss durch einen Widerstandsheizer erfolgen. Ein derartiger Widerstandsheizer wird vorzugsweise innerhalb des Formträgers in der Nähe der Aussparung angeordnet, so daß das flache Kunststoffband nur im Bereich der einzuformenden und zu bestückenden Gurttasche erwärmt wird.

Bei einer anderen Durchführung des Verfahrens wird die Erwärmung des Formträgers und/oder des Kunststoffbandes mittels Stromfluss durch Peltierelemente erzeugt, wobei die Kühlseite der Peltierelemente gleichzeitig der Bereitstellung einer gekühlten Oberfläche zur Berührung mit den Bestückten Gurttaschen dienen kann. Diese Technik hat den Vorteil, daß auf relativ engem Raum ein deutlicher Temperaturunterschied zwischen einer zu erwärmenden Fläche und einer zu kühlenden Seite durch Stromschluß möglich wird, wobei die Peltierelemente unmittelbar entweder in den Formträger oder in den Träger der zu kühlenden Oberfläche einbaubar sind.

Während die Erwärmung mittels Widerstandsheizer oder Peltierelementen bevorzugt in dem Formkörper durchgeführt werden kann, erfolgt die Erwärmung des Kunststoffbandes in einer anderen Durchführung des Verfahrens mittels Wärmestrahlung einer Wärmequelle. Die Wärmequelle kann in einer Durchführung des Verfahrens Infrarotstrahlen liefern. Diese Strahlungsart hat insbesondere einen erheblichen Vorteil, wenn das Kunststoffband mit einem Graphit- oder Kohlenstofffüller versehen ist, der darüber hinaus eine elektrostatische Aufladung des Kunststoffbandes an seiner Oberfläche verhindern soll. Dieser Graphit- oder Kohlenstofffüller absorbiert mit hohem Wirkungsgrad Infrarotstrahlen und heizt damit das Kunststoffband auf. Die Infrarotbestrahlung hat weiterhin den Vorteil, daß das Kunststoffband exakt in dem Bereich aufgeheizt werden kann, in dem die nächste Gurttasche zu formen ist, da durch geeignete optische Blenden der Einwirkbereich der Infrarotstrahlen eingegrenzt werden kann. Da das umgebende Material des Kunststoffbandes praktisch auf Raumtemperatur bleibt, wird das Kunststoffband im Randbereich, in dem auch eine Transportperforation angebracht sein kann, nicht verändert und maßgetreu beibehalten.

Nach der Einformung und Bestückung der Gurttaschen wird in einer weiteren Durchführung des Verfahrens der bestückte Transportgurt mittels Abdeckgurtband mindestens im Bereich der bestückten Gurttaschen abgedeckt. Dieses Abdecken kann durch Verschweißen des Abdeckgurtbandes mit dem Transportgurt oder durch Verkleben derselben miteinander zusätzlich gesichert werden.

Beim Einformen der Gurttasche wird in einer weiteren Durchführung des Verfahrens der Bodenbereich der Gurttasche mittels Evakuieren des Zwischenraums zwischen Gurttaschenboden und Aussparungsboden geformt. Dieses hat den Vorteil, daß der Bodenbereich der Gurttasche eng auf dem Boden der Aussparung aufliegt und somit die Tiefe der Gurttasche durch die Tiefe der Aussparung bestimmt wird und keinerlei Abweichungen in der Tiefe beim einfachen Einpressen des Prägewerkzeugs in die Aussparungen des Formträgers auftreten können.

Eine für das Evakuieren des Zwischenraums zwischen Gurttaschenboden und Aussparungsboden vorgesehene zentrale Bohrung im Formträger kann in einer weiteren Durchführung des Verfahrens dazu dienen, den Bodenbereich der Gurttasche von dem Bodenbereich der Aussparung nach Bestücken der Gurttasche mit einem elektronischen Bauteil durch Einpressen eines gasförmigen Mediums zwischen dem Bodenbereich der Gurttasche und dem Bodenbereich der Aussparung zu trennen. Somit ergibt sich der Vorteil einer zuverlässigen Einformung und Ausformung des Bodenbereichs der Gurttasche sowie einer sicheren Trennung zwischen Gurttasche und Formträger, ohne daß das Bauteil während dieses Vorgangs aus der Gurttasche herausspringt, zumal in dieser Verfahrensphase das Prägewerkzeug das Bauteil in Position halten kann und erst nach dem Entfernen des Formträgers sich von dem elektronischen Bauteil in seinem Prägebereich trennt. Zum Trennen von Prägewerkzeug und elektronischem Bauteil kann über eine zentrale Bohrung im Prägewerkzeug unter Einführen eines gasförmigen Mediums das elektronische Bauteil in der Gurttasche gehalten werden, während das Prägewerkzeug von dem elektronischen Bauteil abgehoben wird.

Die Trennung von Formträger und Gurttasche bzw. von Formträger und bestücktem Transportgurt kann im wesentlichen auf zwei Arten erfolgen. In der einen Durchführungsform des Verfahrens wird der Formträger gegenüber dem bestückten Transportgurt abgesenkt und in einer anderen Durchführung des Verfahrens wird die bestückte Gurttasche von dem Formträger durch Drehen des Formträgers um eine Drehachse unter gleichzeitiger horizontaler Verschiebung des Transportgurtes getrennt. Mit beiden Durchführungsarten wird sichergestellt, daß der bestückte Transportgurt seine horizontale Lage bis zum Abdecken mit einem Abdeckgurtband beibehält.

Sobald ein Abdeckgurtband die Gurttaschen verschließt, kann der Transportgurt jede beliebige Lage im Raum einnehmen, ohne daß das elektronische Bauteil herausfällt oder sich um eine der Raumachsen in der Gurttasche verdreht, so daß das elektronische Bauteil bis zum Abnehmer lagegetreu transportiert werden kann. Werden Transportgurtband und Abdeckgurtband gemeinsam auf einen Rotationskörper aufgewickelt, so ist gleichzeitig die Gewähr gegeben, daß ein minimaler Lagerraumbereich und ein minimaler Transportraumbereich für den bestückten Transportgurt benötigt werden.

Das Bestücken eines Transportgurtes wird auch Gurtung genannt, wobei Transportgurte, die lediglich aus einer Kunststofffolie mit Gurttaschen bestehen, auch als Blistergurte bekannt sind. Die sogenannte Blistergurtung bei kleinen oder leichten Bauteilen benötigt einen sehr eng tolerierten Blistergurt, um bei hohen UPH ein Herausspringen der Bauteile aus dem Gurt zu verhindern. Gleichzeitig ergibt sich dadurch die Anforderung an den Blistergurt, daß eine Gurtanlage oder auch Bestückungsautomat mit hoher Präzision die Bauteile in den Gurt ablegen muß, was wiederum den UPH-Wert absenken könnte. Deshalb wird in der erfindungsgemäßen Lösung der Gurtanlage ein flacher Rohgurt zugeführt, in den unter Temperatur und Druck Näpfchen oder auch Gurttaschen mit Hilfe der Bauteile tiefgezogen werden. Damit kann der Blistergurt für das jeweilige Bauteil optimal angepaßt sein und die Toleranzen, die durch die Gurtanlage einzuhalten sind, können minimiert werden. Die Taktzeiten der Gurtanlage sowie der Pickanlage beim Kunden, die der Entnahme der Bauteile aus dem Transportgurt dient, werden im Prinzip nicht nachteilig beeinflußt. Gleichzeitig aber können die Kosten für einen Blistergurt reduziert werden, da lediglich ein flacher Rohgurt der Anlage zugeführt werden muß. Dieser flache Blistergurt kann über eine Setzmatrize oder Formträger gelegt werden und das Bauteil mit dem Blistergurt in die Setzmatrize eingebracht werden. Dieses Einbringen kann mit Hilfe einer Vakuumunterstützung und einer gewissen Einpresskraft über das Bauteil geschehen. Unter Umständen muß das Bauteil in dieser Matrize in X- und Y-Richtung noch zusätzlich bewegt werden, damit das Bauteil in dem Gurt nicht eingeklemmt ist und somit wieder leicht beim Kunden entfernt werden kann.

Die Erfindung wird nun anhand von Ausführungsformen mit Bezug auf die angefügten Figuren näher erläutert.
- Figur 1: zeigt einen prinzipiellen Querschnitt durch eine Ausführungsform der Erfindung,
- Figur 2: zeigt eine Prinzipskizze eines Bestückungsautomaten einer weiteren Ausführungsform der Erfindung und
- Figur 3: zeigt eine Prinzipskizze eines Bestückungsautomaten einer dritten Ausführungsform der Erfindung.

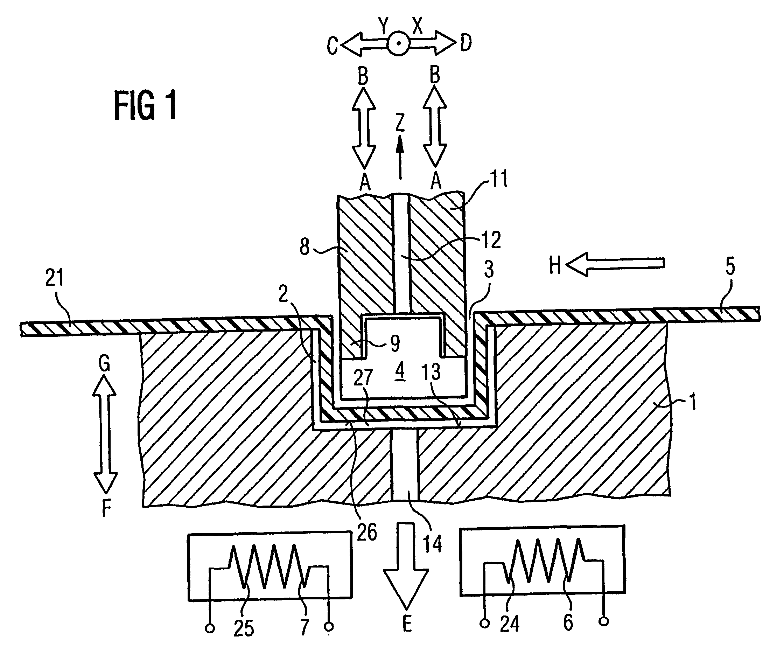

Figur 1 zeigt einen prinzipiellen Querschnitt durch eine Ausführungsform der Erfindung. Diese Ausführungsform dient der Bestückung von Transportgurten 21 mit elektronischen Bauteilen 4. Dazu weist ein Formträger 1 eine Aussparung 2 zur Formgebung von Gurttaschen 3 auf. Ein Kunststoffband 5 wird flach auf dem Formträger 1 angeordnet und im Bereich der Aussparung 2 des Formträgers zu einer Gurttasche 3 ausgeformt.

In die Gurttasche 3 hinein ragt zur Ausformung der Gurttasche 3 ein Prägewerkzeug 8, das in seinem Prägebereich 9 ein elektronisches Bauteil 4 trägt, so daß die Abmessungen der Gurttasche 3 in engen Toleranzen den elektronischen Bauteilen 4 angepasst werden kann. Über eine zentrale Bohrung 14 im Formträger 1 kann mindestens im Bodenbereich der Aussparung der Zwischenraum zwischen Formträger 1 und Kunststoffband 5 minimiert werden, so daß die Tiefe der Gurttasche 3 durch die Tiefe der Aussparung bestimmt wird. Dazu wird in Pfeilrichtung E die Luft aus dem Zwischenraum 27 abgepumpt. Elektrische Widerstandsheizer 6, 7 sind im Formträger 1 in der Nähe der Aussparung 2 angeordnet, um den Formträger zu erwärmen und das Einformen einer Gurttasche 3 in das Kunststoffband 5 zu erleichtern.

Das Kunststoffband 5 ist in dieser Ausführungsform aus einem Polycarbonat oder einem Polystyrolmaterial, das mit einem Graphitfüller eingeschwärzt wird, womit der Oberflächenwiderstand des Kunststoffbandes 5 derart herabgesetzt wird, daß keine elektrostatische Aufladung durch Reibbewegungen zwischen elektronischen Bauteil 4 und Kunststoff-Gurttasche 3 beim Ausbilden der Gurttasche das elektronische Bauteil 4 gefährden kann. Das Prägewerkzeug 8 ist in dieser Ausführungsform als Prägestempel 11 ausgebildet, mit einer zentralen evakuierbaren Bohrung 12. Diese Bohrung 12 wird zur lagegetreuen Aufnahme des elektronischen Bauteils in den Prägebereich 9 des Prägestempels 11 evakuiert und wirkt folglich wie eine Vakuumpinzette.

Nach dem Einprägen der Gurttasche 3 in das flache Kunststoffband 5 kann die Vakuumpinzette von einem Vakuum auf einen Luftstrom umgeschaltet werden, so daß das elektronische Bauteil 4 von dem Prägestempel 11 getrennt wird. Der Prägestempel 11 kann somit unter Zurücklassung des elektronischen Bauteils 4 in der Gurttasche 3 in Pfeilrichtung B abgezogen werden. Auch der Formträger 1 kann in Pfeilrichtung F von dem bestückten Transportgurt 21 abgezogen werden, wobei das Trennen des Formträgers 1 von dem Kunststoffband 5 durch Einblasen eines Gasmediums durch die Bohrung 14 im Formträger 1 unterstützt werden kann.

Nach Abziehen des Formträgers 1 von dem bestückten Transportgurts 21 kann dieser in horizontaler Richtung H mit dem in der Gurttasche 3 positionierten elektronischen Bauteil 4 abtransportiert werden, während das flache Kunststoffband 5 die nächste Bestückungsposition einnimmt, in der das nächste Bauteil, das von dem Prägewerkzeug 8 aufgenommen wird, in einer zu formenden Gurttasche 3 im Kunststoffband 5 abgelegt wird. Dazu wird wiederum das Prägewerkzeug 8 in Pfeilrichtung A abgesenkt und eventuell gleichzeitig der Zwischenraum 27 zwischen Kunststoffband 5 und der Aussparung 2 im Formträger 1 durch Anlegen eines Vakuums an die evakuierbare Bohrung 14 minimiert.

Bei dem Eindrücken des elektronischen Bauteils 4 in die Aussparung 2 des Formträgers 1 kann gleichzeitig das Prägewerkzeug 8 in den Pfeilrichtungen C und D vibrieren, so daß eine eng tolerierbare lose Passung zwischen elektronischen Bauteil 4 und Innenseite der Gurttasche 3 entsteht. Diese lose Passung sorgt einerseits dafür, daß das elektronische Bauteil sich bewegen kann, jedoch in seiner Bewegung derart begrenzt ist, daß es sich um keine der drei Raumachsen (Hochachse, Längsachse, Querachse) verdrehen kann, so daß das elektronische Bauteil 4 in der angepassten Gurttasche 3 lagegetreu verpackt, transportiert und wieder dem Transportgurt 21 entnommen werden kann.

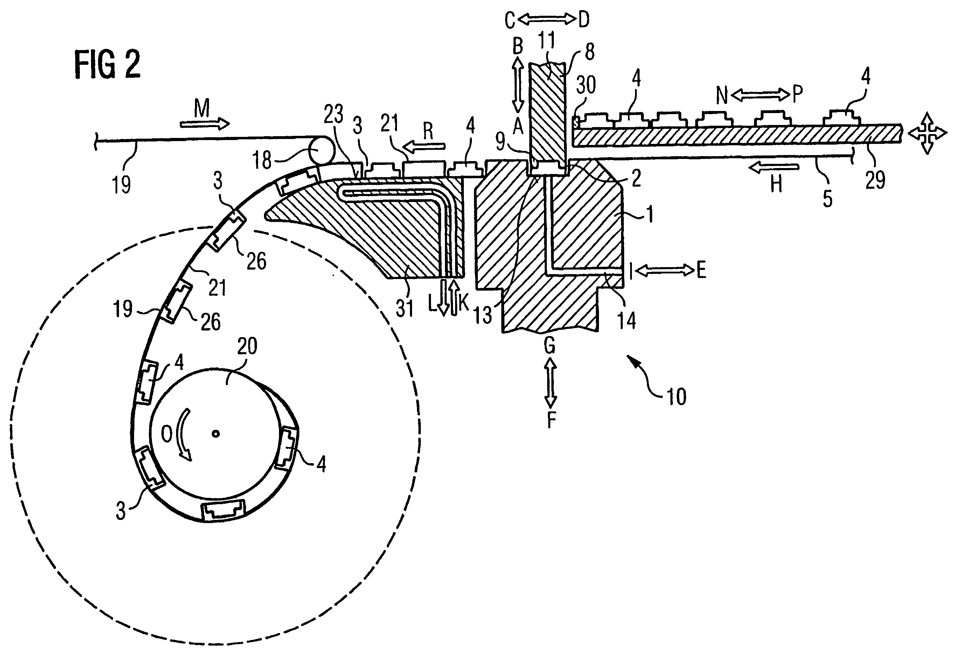

Figur 2 zeigt eine Prinzipskizze eines Bestückungsautomaten 10 einer weiteren Ausführungsform der Erfindung. Die Bezugszeichen werden in Figur 2, soweit sie gleiche Bauelemente wie in Figur 1 bezeichnen, beibehalten. Das Bezugszeichen 29 bezeichnet eine Schüttelrinne, über die in Richtung N elektronische Bauteile 4 bis zu einem Anschlag 30 transportiert werden. Das Bezugszeichen 23 kennzeichnet eine gekühlte Oberfläche, auf der die mit elektronischen Bauteilen 4 bestückten Gurttaschen 3 gekühlt werden. Die Kühlung der Oberfläche 23 kann mittels Kühlflüssigkeit erfolgen, die in Richtung K in ein Kühlkanalsystem in den Kühlkörper 31 eingeleitet wird und in Richtung L den Kühlkörper 31 verlässt.

Ferner zeigt der Bestückungsautomat 10 der Figur 2 ein Abdeckgurtband 19, das in Pfeilrichtung M über eine Umlenkrolle 18 dem Transportgurt 21 zugeführt wird und die Gurttaschen 3 des Transportgurtes 21 abdeckt, wobei der Transportgurt 21 mit darauf angeordneten Abdeckgurtband 19 auf einem Rotationskörper 20 zur raumsparenden Lagerung und zum raumsparenden Transport in Pfeilrichtung O aufgewickelt wird.

Die zentrale Vorrichtung des Bestückungsautomaten 10 zum Bestücken eines Transportgurtes 21 mit elektronischen Bauteilen 4 entspricht der Figur 1, wobei ein Prägewerkzeug 8 mit einem an seinem Prägebereich 9 angeordneten elektronischen Bauteil 4 in das Kunststoffband 5 eine Gurttasche 3 einprägt unter gleichzeitiger Anordnung des elektronischen Bauteils 4 in der Gurttasche 3. Zur Ausformung der Gurttasche 3 ist in einem Formträger, der durch einen nicht gezeigten Hubstempel in den Pfeilrichtungen G und F bewegt werden kann, eine Aussparung vorgesehen. Im Einzelnen werden mit der Vorrichtung nach Figur 2 folgende Verfahrenssschritte durchgeführt.

Das Prägewerkzeug 8 wird in Pfeilrichtung B über das Niveau der Schüttelrinne 29 angehoben. Die Schüttelrinne 29 wird in Richtung N vorgeschoben, so daß das Prägewerkzeug 8 in Pfeilrichtung A auf ein elektronisches Bauteil 4 am Anschlag 30 der Schüttelrinne 29 abgesenkt werden kann. Durch Anlegen eines Vakuums an eine in Figur 1 gezeigte zentrale Bohrung des Prägewerkzeugs 8 wird das elektronische Bauteil 4 im Prägebereich 9 des Prägewerkzeugs 8 angeordnet. Danach wird die Schüttelrinne 29 aus dem Prägebereich 9 des Prägewerkzeugs 8 in Pfreilrichtung P abgezogen und das Prägewerkzeug 8 auf das Kunststoffband 5, das flach auf dem Formträger 1 aufliegt, abgesenkt. Während dieser Absenkung wird einerseits das elektronische Bauteil 4 mittels Vakuum in dem Prägebereich 9 des Prägewerkzeugs 8 fixiert und andererseits ein Vakuum an die Bohrung 14 im Formträger 1 angelegt. Durch zusätzliche Bewegung des Prägewerkzeugs 8 in den Pfeilrichtungen C und D wird eine Gurttasche 3 in der Aussparung 2 ausgeformt, die eine lose und doch eng tolerierte Passung des elektronischen Bauteils 4 in der Gurttasche 3 gewährleistet.

Nach dem Ausformen der Gurttasche 3 wird zunächst in Pfeilrichtung I ein Luftstrom in die Bohrung 14 eingelassen und der Formträger 1 von dem bestückten Transportgurt 21 getrennt und in Pfeilrichtung F nach unten abgezogen. Danach wird durch Abschalten des Vakuums von der zentralen Bohrung des Prägewerkzeugs 8 oder durch Umschalten auf einen Gasstrom das elektronische Bauteil 4 von dem Prägewerkzeug 8 getrennt, so daß das elektronische Bauteil 4 in loser Passung in der Gurttasche 3 des Transportgurtes 21 verbleibt. Die Gurttasche 3 wird jetzt um eine Position horizontal in Pfeilrichtung R verschoben und die noch erwärmte Gurttasche 3 wird auf der gekühlten Oberfläche 23 abgekühlt, während die Aussparung 2 des Formträgers 1 von dem flachen Kunststoffband 5 erneut abgedeckt wird.

Zur Einprägung des nächsten Bauteils in das Kunststoffband 5 wird ein weiteres elektronisches Bauteil 4 von dem Prägewerkzeug 8 im Prägebereich 9 aufgenommen. Dieser getaktete Vorgang der Bestückung des Transportgurtes 21 kann mit hoher Geschwindigkeit fortgesetzt werden, ohne daß allzu hohe Anforderungen an die Präzision der Prägewerkzeuge der Aussparungen oder des Formträgers gestellt werden müssen, zumal die Form des elektronischen Bauteils 4 die Größe der Gurttaschen 3 bestimmt. Da die abgekühlten Gurttaschen wesentlich steifer sind als die Zwischenabschnitte des bestückten Transportgurtes 21, ist es möglich, nach Abdecken der Gurttaschen 3 durch das Abdeckgurtband 19 in Pfeilrichtung M den Transportgurt 21 in beliebiger Lage zu transportieren und zu speichern. In diesem Fall der Ausführungsform der Figur 2 wird der Transportgurt 21 zusammen mit dem Abdeckgurtband 19 auf einen Rotationskörper 20 aufgewickelt.

Der Vorteil dieser automatischen Bestückungsanlage entsprechend der Figur 2 ist, daß eine sichere, zuverlässige und lagegetreue Bestückung eines Transportgurtes 21 mit äußerst kurzen Taktzeiten möglich ist.

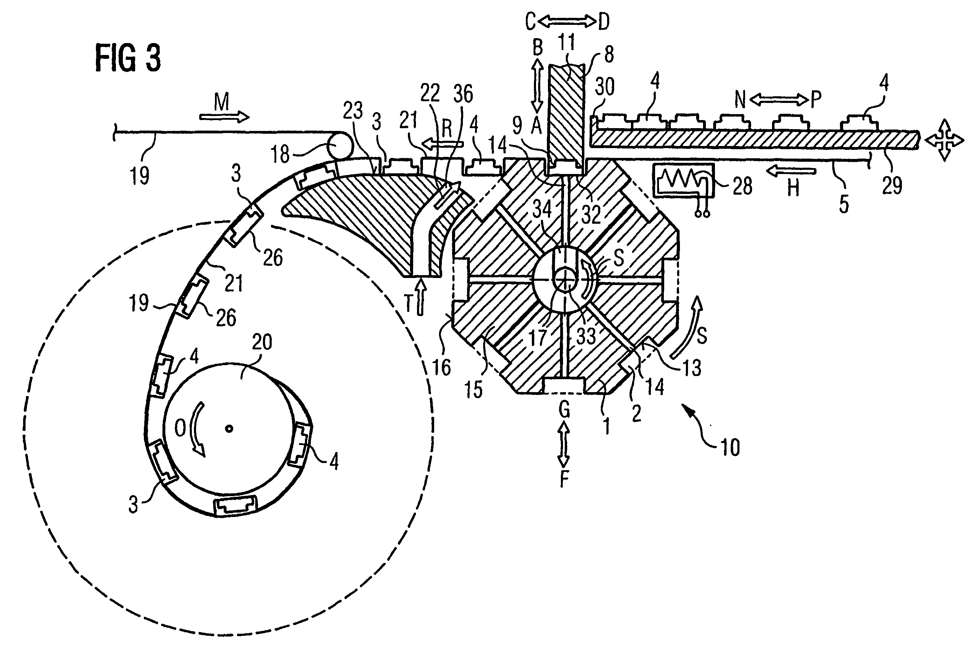

Figur 3 zeigt eine Prinzipskizze eines Bestückungsautomaten 10 einer dritten Ausführungsform der Erfindung. Gleiche Bauelemente der Figur 3 sind mit den gleichen Bezugszeichen wie in den Figuren 1 und 2 bezeichnet. Im Unterschied zur Ausführungsform der Figur 1 und der Figur 2 ist der Formträger 1 nicht mit einem Hubstempel verbunden, sondern als eine polygonale Säule 15 ausgebildet, wobei die Kantenflächen der polygonalen Säule 15 Aussparungen 2 tragen. Diese Aussparungen 2 können identische Dimensionen haben und durch Drehen in Pfeilrichtung S des Formträgers 1 um seine Rotationsachse 17 nacheinander in die Bestückungsposition 32 gedreht werden. Dazu muß vorher das Prägewerkzeug 8 in Pfeilrichtung B angehoben worden sein.

Durch das Drehen des Formträgers 1 um seine Rotationsachse 17 wird an den polygonalen Ecken der bestückte Transportgurt 21 angehoben, so daß die Gurttasche 3 mit elektronischem Bauteil aus dem Formträger 1 herausgehoben wird. Gleichzeitig kann über die zentrale Bohrung 14 ein Luftstrom diesen Vorgang unterstützen. Die zentrale Bohrung 14 wird während des Prägevorgangs über die axiale Bohrung 33 und die radiale Bohrung 34 in der Welle 35 mit Vakuum versorgt, um den Bodenbereich der Gurttasche 3 eng an den Bodenbereich der Aussparung 2 im Formträger 1 anzupassen.

Im Unterschied zur ersten Ausführung der Figur 1 wird in der dritten Ausführungsform der Figur 3 nicht der Formträger 1 erwärmt, sondern das Kunststoffband 5 über den Heizer 28 für das Kunststoffband 5 lokal an der zu bildenden Stelle einer Gurttasche 3 in der nächstfolgenden Position vorgewärmt. Zwar ist in dieser Ausführungsform der Figur 3 als Heizer 28 eine Widerstandsheizung vorgesehen, jedoch wird an dieser Stelle auch vorteilhaft eine Infrarotstrahlung eingesetzt, um mittels Blenden den erwärmten Bereich des Kunststoffbandes 5 auf den für die nächste Gurttasche notwendigen Bereich zu begrenzen.

Anstelle des in Figur 2 gezeigten wassergekühlten Kühlkörpers ist in dieser Ausführungsform ein Kühlkörper 31 vorgesehen, der über einen Luftstrom 22 die bestückten Gurttaschen 3 kühlt. Dazu wird ein gasförmiges Kühlmedium in Pfeilrichtung T einer Kühldüse 36 zugeführt.

Alternativ kann der polygonale Formträger 1 zusätzlich zur Drehbewegung in Pfeilrichtung S eine Hubbewegung in den Pfeilrichtungen F und G ausführen, so daß die polygonalen Kantenflächen 16 der polygonalen Säulenform 15 mit Aussparungen 2 von unterschiedlicher Größe ausgestattet sein können. Die Drehbewegung S um die Rotationsachse 17 wird dann dazu eingesetzt, um die Aussparungen entsprechend den unterschiedlichen Bauteilgrößen einzustellen. Diese alternative Ausführungsform hat den Vorteil, daß relativ schnell zwischen unterschiedlichen Bauteilgrößen gewechselt werden kann, da jeweils die entsprechende Aussparung durch eine einfache Drehbewegung in die Bestückungsposition zu bringen ist.

## Patentansprüche

1. Vorrichtung zur Bestückung von Transportgurten (21) mit elektronischen Bauteilen (4), wobei die Vorrichtung aufweist:
- einen Formträger (1) mit mindestens einer Aussparung (2) zur Formgebung von Gurttaschen (3) für die Aufnahme elektronischen Bauteile (4) in den Gurttaschen,
- ein flaches Kunststoffband (5), das auf dem Formträger (1) die Aussparung (2) abdeckend angeordnet ist, und
- eine Heizung (6, 7, 24, 25, 28) zur Erwärmung, des Formträgers (1) und/oder des Kunststoffbandes 5,
**dadurch gekennzeichnet, daß** die Vorrichtung mit
- einem Prägewerkzeug (8) versehen ist, das in seinem Prägebereich (9) das elektronische Bauteil (4) aufweist, wobei
- die Gurttasche (3) mittels in dem Prägebereich (9) positioniertem elektronischen Bauteil (4) unter Einpressen des Kunststoffbandes (5) in die Aussparung (2) des Formträgers (1) durch das elektronische Bauteil (4) formbar ist.

2. Vorrichtung nach Anspruch 1,
**dadurch gekennzeichnet, daß**
das Prägewerkzeug (8) ein Bestückungselement eines Bestückungsautomaten (10) ist.

3. Vorrichtung nach Anspruch 1 oder Anspruch 2,
**dadurch gekennzeichnet, daß**
das Prägewerkzeug (8) ein Prägestempel (11) ist, in dessen Prägebereich (9) das elektronische Bauteil (4) mittels Vakuum fixierbar ist.

4. Vorrichtung nach einem der vorhergehenden Ansprüche,
**dadurch gekennzeichnet, daß**
das Prägewerkzeug (8) eine zentrale evakuierbare Bohrung (12) aufweist, mittels der das elektronische Bauteil (4) im Prägebereich (3) fixierbar ist.

5. Vorrichtung nach einem der vorhergehenden Ansprüche,
**dadurch gekennzeichnet, daß**
das Prägewerkzeug (8) mit einer Antriebsmechanik verbunden ist, wodurch das Prägewerkzeug (8) in Richtung (Z) auf die Aussparungen (2) in dem Formträger und in den Richtungen (X, Y) orthogonal dazu verschiebbar ist.

6. Vorrichtung nach einem der vorhergehenden Ansprüche,
**dadurch gekennzeichnet, daß**
die Aussparung (2) in dem Formträger (1) in ihrem Bodenbereich (13) eine evakuierbare Bohrung (14) zur Formgebung der Gurttasche (3) im Bodenbereich (13) der Aussparung (2) aufweist.

7. Vorrichtung nach einem der vorhergehenden Ansprüche,
**dadurch gekennzeichnet, daß**
der Formträger (1) eine zylindrische Form aufweist und auf seinem Zylindermantel mindestens eine Aussparung (2) zur Formgebung von Gurttaschen (3) angeordnet ist.

8. Vorrichtung nach einem der vorhergehenden Ansprüche,
**dadurch gekennzeichnet, daß**
der Formträger (1) eine polygonale Säulenform (15) aufweist und auf seinen polygonalen Kantenflächen (16) jeweils mindestens eine Aussparung (2) zur Formgebung von Gurttaschen (3) angeordnet ist.

9. Vorrichtung nach einem der vorhergehenden Ansprüche,
**dadurch gekennzeichnet, daß**
der Formträger (1) eine Rotationsachse (17) zur Drehung seiner mindestens einen Aussparung (2) in den Prägebereich (9) und aus dem Prägebereich (9) des Prägewerkzeugs (8) heraus aufweist.

10. Vorrichtung nach einem der vorhergehenden Ansprüche,
**dadurch gekennzeichnet, daß**
der Formkörper (1) eine Hubvorrichtung zum Anheben in Richtung auf das Prägewerkzeug (8) zu und zum Absinken in entgegengesetzter Richtung aufweist.

11. Vorrichtung nach einem der vorhergehenden Ansprüche,
**dadurch gekennzeichnet, daß**
das Kunststoffband (5) eine Polystyrolfolie ist.

12. Vorrichtung nach einem der Ansprüche 1 bis 10,
**dadurch gekennzeichnet, daß**
das Kunststoffband (5) eine Polycarbonatfolie ist.

13. Vorrichtung nach einem der vorhergehenden Ansprüche,
**dadurch gekennzeichnet, daß**
das Kunststoffband (5) einen Graphit- oder Kohlenstofffüller aufweist.

14. Vorrichtung nach einem der vorhergehenden Ansprüche,
**dadurch gekennzeichnet, daß**
die Vorrichtung eine Zufuhreinrichtung (18) eines Abdeckgurtbandes (19) zum Abdecken der Gurttaschen (3) aufweist.

15. Vorrichtung nach einem der vorhergehenden Ansprüche,
**dadurch gekennzeichnet, daß**
die Vorrichtung eine Kunststoffschweisseinrichtung aufweist zum Aufschweissen des Abdeckgurtbandes (19) und zum Verschließen der Gurttaschen (3).

16. Vorrichtung nach einem der vorhergehenden Ansprüche,
**dadurch gekennzeichnet, daß**
die Vorrichtung einen Rotationskörper (20) zum Aufwikkeln des Transportgurtes (21) mit in den Gurttaschen (3) angeordneten elektronischen Bauteilen (4) aufweist.

17. Verfahren zum Bestücken von Transportgurten (21) mit elektronischen Bauteilen (4), das folgende Verfahrensschritte aufweist:
- Bereitstellen eines Formträgers (1) mit mindestens einer Aussparung (2) für Gurttaschen (3) zur Aufnahme elektronischer Bauteile 4,
- Positionieren eines verformbaren flachen Kunststoffbandes (5) auf dem Formträger (1) im Bereich der Aussparung (2),
- Erwärmen des Formträgers (1) und/oder des Kunststoffbandes (5),
- Aufnehmen eines elektronischen Bauteils (4) mittels eines Prägewerkzeugs (8) und Anordnen des elektronischen Bauteils (4) im Prägebereich (9) des Prägewerkzeugs (8),
- Einpressen des Prägebereichs (9) des Prägewerkzeugs (8) in die Aussparung (2) des Formträgers (3) unter Ausformung einer Gurttasche (3) in dem auf der Aussparung (2) angeordneten Kunststoffband (5),
- Entfernen des Prägewerkzeugs (8) aus der Gurttasche (3) unter Zurücklassung des elektronischen Bauteils (4) in der Gurttasche (3).

18. Verfahren nach Anspruch 17,
**dadurch gekennzeichnet, daß**
das Prägewerkzeug (8) beim Einpressen in die Aussparung (2) in den Richtungen orthogonal zu der Einpressrichtung bewegt wird.

19. Verfahren nach Anspruch 17 oder Anspruch 18,
**dadurch gekennzeichnet, daß**
das Prägewerkzeug (8) und der Formträger (1) nach dem Ausformen der Gurttasche (3) unter gleichzeitiger Bestückung derselben mit einem elektronischen Bauteil (4) auseinander gefahren werden und der entstandene Transportgurt (21) bestückt mit einem elektronischen Bauteil (4) in der Gurttasche (3) aus der Bestückungsposition herausgefahren wird, während das flache Kunststoffband (5) die nächste Bestückungsposition einnimmt.

20. Verfahren nach einem der Ansprüche 17 bis 19,
**dadurch gekennzeichnet, daß**
das Prägewerkzeug (8) nach dem Ausformen und dem gleichzeitigen Bestücken einer Gurttasche (3) mit einem elektronischen Bauteil (4) das nächste elektronische Bauteil (4) in seinen Prägebereich (9) aufnimmt.

21. Verfahren nach einem der Ansprüche 17 bis 20,
**dadurch gekennzeichnet, daß**
der Transportgurt (21) nach dem Einformen und gleichzeitigen Bestücken einer Gurttasche (3) in dem Bereich der bestückten Gurttasche (3) gekühlt wird.

22. Verfahren nach einem der Ansprüche 17 bis 21,
**dadurch gekennzeichnet, daß**
die bestückte Gurttasche (3) in einem Luftstrom (22) gekühlt wird.

23. Verfahren nach einem der Ansprüche 17 bis 21,
**dadurch gekennzeichnet, daß**
die bestückte Gurttasche (3) zum Kühlen über eine wassergekühlte Oberfläche (23) geführt wird.

24. Verfahren nach einem der Ansprüche 17 bis 23,
**dadurch gekennzeichnet, daß**
die Erwärmung des Formträgers (1) mittels Stromfluß durch einen Widerstandsheizer (6, 7, 24, 25, 28) erzeugt wird.

25. Verfahren nach einem der Ansprüche 17 bis 23,
**dadurch gekennzeichnet, daß**
die Erwärmung des Formträgers (1) mittels Stromfluß durch Peltierelemente erzeugt wird, wobei die Kühlseite der Peltierelemente gleichzeitig der Bereitstellung einer gekühlten Oberfläche (23) zur Berührung mit den bestückten Gurttaschen (3) dient.

26. Verfahren nach einem der Ansprüche 17 bis 23,
**dadurch gekennzeichnet, daß**
die Erwärmung des Kunststoffbandes (5) mittels Wärmestrahlung einer Wärmequelle erfolgt.

27. Verfahren nach einem der Ansprüche 17 bis 23,
**dadurch gekennzeichnet, daß**
die Erwärmung des Kunststoffbandes (5) mittels Infrarotstrahlen erfolgt.

28. Vorrichtung nach einem der Ansprüche 17 bis 27,
**dadurch gekennzeichnet, daß**
der bestückte Transportgurt (21) mittels eines Abdeckgurtbandes (19) mindestens im Bereich der bestückten Gurttaschen (3) abgedeckt wird.

29. Verfahren nach einem der Ansprüche 17 bis 28,
**dadurch gekennzeichnet, daß**
der Bodenbereich (26) der Gurttasche (3) mittels Evakuieren des Zwischenraums (27) zwischen Gurttaschenboden (26) und Aussparungsboden (13) geformt wird.

30. Verfahren nach einem der Ansprüche 17 bis 29,
**dadurch gekennzeichnet, daß**
der Bodenbereich (26) der Gurttasche (3) und der Bodenbereich (13) der Aussparung (2) nach Bestücken der Gurttasche (3) mit einem elektronischen Bauteil (4) durch Einpressen eines gasförmigen Mediums zwischen dem Bodenbereich (26) der Gurttasche (3) und dem Bodenbereich (13) der Aussparungen (2) voneinander getrennt werden.

31. Verfahren nach einem der Ansprüche 17 bis 30,
**dadurch gekennzeichnet, daß**
die bestückte Gurttasche (3) von dem Formträger (1) durch Absenken des Formträgers (1) getrennt wird.

32. Verfahren nach einem der Ansprüche 17 bis 30,
**dadurch gekennzeichnet, daß**
die bestückte Gurttasche (3) von dem Formträger (1) durch Drehen des Formträgers (1) um eine Rotationsachse (17) unter gleichzeitig horizontaler Verschiebung des Transportgurtes (21) getrennt wird.

33. Verfahren nach einem der Ansprüche 17 bis 32,
**dadurch gekennzeichnet, daß**
der Transportgurt (21) mit einem Abdeckgurtband (19) gemeinsam auf einen Rotationskörper (20) gewickelt wird.

## Claims

1. Apparatus for populating transport tapes (21) with electronic components (4), the apparatus having:
- a mould support (1) having at least one recess (2) for shaping tape pockets (3) to hold electronic components (4) in the tape pockets,
- a flat plastic strip (5), which is arranged on the mould support (1), covering the recess (2), and
- a heater (6, 7, 24, 25, 28) for heating the mould support (1) and/or the plastic strip (5),
- **characterized in that** the apparatus is provided with
- an embossing tool (8), which has the electronic component (4) in its embossing area (9),
it being possible for the tape pocket (3) to be moulded by means of the electronic component (4) positioned in the embossing area (9) as the electronic component (4) presses the plastic strip (5) into the recess (2) in the mould support (1).

2. Apparatus according to Claim 1, **characterized in that** the embossing tool (8) is a fitting element of an automatic fitting machine (10).

3. Apparatus according to Claim 1 or Claim 2, **characterized in that** the embossing tool (8) is an embossing punch (11), in whose embossing area (9) the electronic component (4) can be fixed by means of vacuum.

4. Apparatus according to one of the preceding claims, **characterized in that** the embossing tool (8) has a central evacuable bore (12), by means of which the electronic component (4) can be fixed in the embossing area (3).

5. Apparatus according to one of the preceding claims, **characterized in that** the embossing tool (8) is connected to a drive mechanism, by means of which the embossing tool (8) can be displaced in the direction (Z) of the recesses (2) in the mould support and in the directions (X, Y) orthogonal thereto.

6. Apparatus according to one of the preceding claims, **characterized in that** the recess (2) in the mould support (1) has, in its bottom area (30), an evacuable bore (14) for shaping the tape pocket (3) in the bottom area (13) of the recess (2).

7. Apparatus according to one of the. preceding claims, **characterized in that** the mould support (1) has a cylindrical shape and at least one recess (2) for shaping tape pockets (3) is arranged on its cylinder jacket.

8. Apparatus according to one of the preceding claims, **characterized in that** the mould support (1) has a polygonal columnar shape (15) and in each case at least one recess (2) for shaping tape pockets (3) is arranged on its polygonal edge surfaces (16).

9. Apparatus according to one of the preceding claims, **characterized in that** the mould support (1) has an axis of rotation (17) in order to rotate its at least one recess (2) into the embossing area (9) and out of the embossing area (9) of the embossing tool (8).

10. Apparatus according to one of the preceding claims, **characterized in that** the body of the mould (1) has a lifting device for lifting it in the direction of the embossing tool (8) and for lowering it in the opposite direction.

11. Apparatus according to one of the preceding claims, **characterized in that** the plastic strip (5) is a polystyrene film.

12. Apparatus according to one of Claims 1 to 10, **characterized in that** the plastic strip (5) is a polycarbonate film.

13. Apparatus according to one of the preceding claims, **characterized in that** the plastic strip (5) has a graphite or carbon filler.

14. Apparatus according to one of the preceding claims, **characterized in that** the apparatus has a feed device (18) for a cover tape strip (19) for covering the tape pockets (3).

15. Apparatus according to one of the preceding claims, **characterized in that** the apparatus has a plastic welding device for welding the cover tape strip (19) on and for closing the tape pockets (3).

16. Apparatus according to one of the preceding claims, **characterized in that** the apparatus has a rotational body (20) for winding up the transport tape (21) with electronic components (4) arranged in the tape pockets (3).

17. Method of populating transport tapes (21) with electronic components (4), which has the following method steps:
- providing a mould support (1) with at least one recess (2) for tape pockets (3) to hold electronic components (4),
- positioning a deformable flat plastic strip (5) on the mould support (1) in the area of the recess (2),
- heating the mould support (1) and/or the plastic strip (5),
- picking up an electronic component (4) by means of an embossing tool (8) and arranging the electronic component (4) in the embossing area (9) of the embossing tool (8),
- pressing the embossing area (9) of the embossing tool (8) into the recess (2) in the mould support (1) while forming a tape pocket (3) in the plastic strip (5) arranged on the recess (2),
- removing the embossing tool (8) from the tape pocket (3) while leaving the electronic component (4) in the tape pocket (3).

18. Method according to Claim 17, **characterized in that** the embossing tool (8) is moved in the directions orthogonal to the pressing direction as it is pressed into the recess (2).

19. Method according to Claim 17 or Claim 18, **characterized in that** the embossing tool (8) and the mould carrier (1) are moved apart after the tape pocket (3) has been moulded, the latter being populated with an electronic component (4) at the same time, and the transport tape (21) produced and populated with an electronic component (4) in the tape pocket (3) is moved out of the populating position, while the flat plastic strip (5) assumes the next populating position.

20. Method according to one of Claims 17 to 19, **characterized in that**, after the moulding and simultaneous population of a tape pocket (3) with an electronic component (4), the embossing tool (8) accommodates the next electronic component (4) in its embossing area (9).

21. Method according to one of Claims 17 to 20, **characterized in that**, after the moulding and simultaneous population of a tape pocket (3), the transport tape (21) is cooled in the area of the populated tape pocket (3).

22. Method according to one of Claims 17 to 21, **characterized in that** the populated tape pocket (3) is cooled in an air stream (22).

23. Method according to one of Claims 17 to 21, **characterized in that** the populated tape pocket (3) is guided over a water-cooled surface (23) for the purpose of cooling.

24. Method according to one of Claims 17 to 23, **characterized in that** the heating of the mould support (1) is produced by means of a current flow through a resistance heater (6, 7, 24, 25, 28).

25. Method according to one of Claims 17 to 23, **characterized in that** the heating of the mould support (1) is produced by means of a current flow through Peltier elements, the cooling side of the Peltier elements being used at the same time to provide a cooled surface (23) for contact with the populated tape pockets (3).

26. Method according to one of Claims 17 to 23, **characterized in that** the heating of the plastic strip (5) is carried out by means of radiant heat from a heat source.

27. Method according to one of Claims 17 to 23, **characterized in that** the heating of the plastic strip (5) is carried out by means of infrared rays.

28. The apparatus according to one of Claims 17 to 27, **characterized in that** the populated transport tape (21) is covered by means of a cover tape strip (19), at least in the area of the populated tape pockets (3).

29. Method according to one of Claims 17 to 28, **characterized in that** the bottom area (26) of the tape pocket (3) is moulded by means of evacuating the interspace (27) between the bottom of the tape pocket (26) and the bottom of the recess (13).

30. Method according to one of Claims 17 to 29, **characterized in that**, after the tape pocket (3) has been populated with an electronic component (4), the bottom area (26) of the tape pocket (3) and the bottom area (13) of the recess (2) are separated from each other by pressing a gaseous medium in between the bottom area (26) of the tape pocket (3) and the bottom area (13) of the recesses (2).

31. Method according to one of Claims 17 to 30, **characterized in that** the populated tape pocket (3) is separated from the mould support (1) by lowering the mould support (1).

32. Method according to one of Claims 17 to 30, **characterized in that** the populated tape pocket (3) is separated from the mould support (1) by rotating the mould support (1) about an axis of rotation (17), with simultaneous horizontal displacement of the transport tape (21).

33. Method according to one of Claims 17 to 32, **characterized in that** the transport tape (21) is wound onto a rotational body (20) together with a cover tape strip (19).

## Revendications

1. Dispositif pour implanter des composants électroniques (4) dans des bandes de transport (21), le dispositif comportant :
- un support de formage (1) pourvu d'au moins un évidement (2) pour former des poches de bande (3) destinées à recevoir des composants électroniques (4),
- un ruban plat (5) de matière plastique, qui est disposé sur le support de formage (1) en recouvrant l'évidement (2), et
- un chauffage (6, 7, 24, 25, 28) pour chauffer le support de formage (1) et/ou le ruban (5) de matière plastique,
- **caractérisé en ce que** le dispositif est pourvu d'un outil d'emboutissage (8) qui est muni du composant électronique (4) dans sa région d'emboutissage (9),
- la poche de bande (3) pouvant être formée par l'intermédiaire du composant électronique (4) positionné dans la région d'emboutissage (9), avec enfoncement du ruban (5) de matière plastique dans l'évidement (2) du support de formage (1) par le composant électronique (4).

2. Dispositif selon la revendication 1, **caractérisé en ce que** l'outil d'emboutissage (8) est un élément d'implantation d'une machine automatique (10) d'implantation de composants.

3. Dispositif selon la revendication 1 ou 2, **caractérisé en ce que** l'outil d'emboutissage (8) est un poinçon d'emboutissage (11) dans la région d'emboutissage (9) duquel le composant électronique (4) peut être immobilisé au moyen d'un vide.

4. Dispositif selon l'une des revendications précédentes, **caractérisé en ce que** l'outil d'emboutissage (8) comporte un perçage central (12) pouvant être mis au vide, au moyen duquel le composant électronique (4) peut être immobilisé dans la région d' emboutissage (9).

5. Dispositif selon l'une des revendications précédentes, **caractérisé en ce que** l'outil d'emboutissage (8) est relié à un mécanisme d'entraînement, de sorte que l'outil d'emboutissage (8) peut être déplacé dans la direction (Z) sur les évidements (2) dans le support de formage, et dans les directions (X, Y) orthogonales à la direction (Z).

6. Dispositif selon l'une des revendications précédentes, **caractérisé en ce que** l'évidement (2) dans le support de formage (1) comporte, dans sa région de fond (13), un perçage (14) pouvant être mis au vide afin de former la poche de bande (3) dans la région de fond (13) de l'évidement (2).

7. Dispositif selon l'une des revendications précédentes, **caractérisé en ce que** le support de formage (1) possède une forme cylindrique et au moins un évidement (2) pour former des poches de bande (3) est disposé sur son enveloppe cylindrique.

8. Dispositif selon l'une des revendications précédentes, **caractérisé en ce que** le support de formage (1) possède une forme de colonne polygonale (15) et au moins un évidement (2) pour former des poches de bande (3) est disposé sur chacun des côtés (16) du polygone.

9. Dispositif selon l'une des revendications précédentes, **caractérisé en ce que** le support de formage (1) possède un axe de rotation (17) pour faire tourner son évidement (2) au moins unique dans la région d'emboutissage (9) et hors de la région d'emboutissage (9) de l'outil d'emboutissage (8).

10. Dispositif selon l'une des revendications précédentes, **caractérisé en ce que** le corps de formage (1) possède un dispositif de levage pour le soulever en direction de l'outil d'emboutissage (8) et l'abaisser en direction opposée.

11. Dispositif selon l'une des revendications précédentes, **caractérisé en ce que** le ruban (5) de matière plastique est un film de polystyrène.

12. Dispositif selon l'une des revendications 1 à 10, **caractérisé en ce que** le ruban (5) de matière plastique est un film de polycarbonate.

13. Dispositif selon l'une des revendications précédentes, **caractérisé en ce que** le ruban (5) de matière plastique possède une charge de graphite ou de carbone.

14. Dispositif selon l'une des revendications précédentes, **caractérisé en ce que** le dispositif comporte un équipement (18) pour apporter un ruban (19) de bande de recouvrement destiné à recouvrir les poches de bande (3).

15. Dispositif selon l'une des revendications précédentes, **caractérisé en ce que** le dispositif comporte un équipement de soudage de matières plastiques pour souder le ruban (19) de bande de recouvrement et fermer les poches de bande (3).

16. Dispositif selon l'une des revendications précédentes, **caractérisé en ce que** le dispositif comporte un corps de révolution (20) pour enrouler la bande de transport (21) pourvue de composants électroniques (4) disposés dans les poches de bande (3).

17. Procédé pour implanter des composants électroniques (4) dans des bandes de transport (21), qui présente les étapes suivantes :
- mise à disposition d'un support de formage (1) pourvu d'au moins un évidement (2) pour des poches de bande (3) destinées à recevoir des composants électroniques (4),
- positionnement d'un ruban plat (5) de matière plastique déformable sur le support de formage (1) dans la région de l'évidement (2),
- chauffage du support de formage (1) et/ou du ruban (5) de matière plastique,
- prise en charge d'un composant électronique (4) au moyen d'un outil d'emboutissage (8) et disposition du composant électronique (4) dans la région d' emboutissage (9) de l'outil d' emboutissage (8),
- enfoncement de la région d'emboutissage (9) de l'outil d'emboutissage (8) dans l'évidement (2) du support de formage (1) avec formage d'une poche de bande (3) dans le ruban (5) de matière plastique disposé sur l'évidement (2),
- enlèvement de l'outil d'emboutissage (8) de la poche de bande (3), en laissant le composant électronique (4) dans la poche de bande (3).

18. Procédé selon la revendication 17, **caractérisé en ce que** l'outil d'emboutissage (8), lors de l'enfoncement dans l'évidement (2), est déplacé dans les directions orthogonales à la direction d'enfoncement.

19. Procédé selon la revendication 17 ou 18, **caractérisé en ce que** l'outil d'emboutissage (8) et le support de formage (1), à la suite du formage de la poche de bande (3) accompagné de l'implantation d'un composant électronique (4) dans cette poche, sont écartés l'un de l'autre, et la bande de transport (21) obtenue, équipée d'un composant électronique (4) dans la poche de bande (3), est sortie de la position d'implantation tandis que le ruban plat (5) de matière plastique prend la position d'implantation suivante.

20. Procédé selon l'une des revendications 17 à 19, **caractérisé en ce que** l'outil d'emboutissage (8), à la suite du formage accompagné de l'implantation d'un composant électronique (4) dans une poche de bande (3), prend en charge le composant électronique suivant (4) dans sa région d'emboutissage (9).

21. Procédé selon l'une des revendications 17 à 20, **caractérisé en ce que** la bande de transport (21), à la suite du formage accompagné de l'implantation d'un composant dans une poche de bande (3), est refroidie dans la région de la poche de bande équipée (3).

22. Procédé selon l'une des revendications 17 à 21, **caractérisé en ce que** la poche de bande équipée (3) est refroidie dans un flux d'air (22).

23. Procédé selon l'une des revendications 17 à 21, **caractérisé en ce que** la poche de bande équipée (3) est, pour le refroidissement, dirigée sur une surface refroidie par eau (23).

24. Procédé selon l'une des revendications 17 à 23, **caractérisé en ce que** le chauffage du support de formage (1) au moyen d'un flux de courant est produit par un appareil de chauffage par résistance (6, 7, 24, 25, 28).

25. Procédé selon l'une des revendications 17 à 23, **caractérisé en ce que** le chauffage du support de formage (1) au moyen d'un flux de courant est produit par des éléments Peltier, le côté froid des éléments Peltier servant en même temps à fournir une surface refroidie (23) destinée à entrer en contact avec les poches de bande équipées (3).

26. Procédé selon l'une des revendications 17 à 23, **caractérisé en ce que** le chauffage du ruban (5) de matière plastique s'effectue par rayonnement thermique d'une source de chaleur.

27. Procédé selon l'une des revendications 17 à 23, **caractérisé en ce que** le chauffage du ruban (5) de matière plastique s'effectue au moyen de rayons infrarouges.

28. Procédé selon l'une des revendications 17 à 27, **caractérisé en ce que** la bande de transport (21) équipée est recouverte au moyen d'un ruban (19) de bande de recouvrement au moins dans la région des poches de bande équipées (3).

29. Procédé selon l'une des revendications 17 à 28, **caractérisé en ce que** la région de fond (26) de la poche de bande (3) est formée par mise au vide de l'espace intermédiaire (27) entre le fond (26) de la poche de bande et le fond (13) de l'évidement.

30. Procédé selon l'une des revendications 17 à 29, **caractérisé en ce que** la région de fond (26) de la poche de bande (3) et la région de fond (13) de l'évidement (2) sont, à la suite de l'implantation d'un composant électronique (4) dans la poche de bande (3), séparées l'une de l'autre par injection d'un fluide gazeux entre la région de fond (26) de la poche de bande (3) et la région de fond (13) des évidements (2).

31. Procédé selon l'une des revendications 17 à 30, **caractérisé en ce que** la poche de bande équipée (3) est séparée du support de formage (1) par abaissement du support de formage (1).

32. Procédé selon l'une des revendications 17 à 30, **caractérisé en ce que** la poche de bande équipée (3) est séparée du support de formage (1) par une rotation du support de formage (1) autour d'un axe de rotation (17) qui est accompagnée d'un déplacement horizontal de la bande de transport (21).

33. Procédé selon l'une des revendications 17 à 32, **caractérisé en ce que** la bande de transport (21) est enroulée sur un corps de révolution (20) conjointement avec un ruban (19) de bande de recouvrement.
